Europäisches Patentamt

European Patent Office

Office européen des brevets

(19)

(11) Publication number: **0 110 730**
**B1**

(12) **EUROPEAN PATENT SPECIFICATION**

(45) Date of publication of patent specification: **11.05.88**

(51) Int. Cl.⁴: **G 11 B 7/24,** G 11 B 11/10,
G 11 C 13/06 // H01F10/26

(21) Application number: **83307424.8**

(22) Date of filing: **06.12.83**

(54) **Improvements relating to data storage and recording.**

(30) Priority: **06.12.82 GB 8234722**
**09.11.83 GB 8329859**

(43) Date of publication of application:
**13.06.84 Bulletin 84/24**

(45) Publication of the grant of the patent:
**11.05.88 Bulletin 88/19**

(84) Designated Contracting States:
**AT BE CH DE FR GB IT LI LU NL SE**

(56) References cited:
**EP-A-0 025 253**
**DE-A-2 235 574**
**FR-A-2 116 335**
**FR-A-2 184 802**
**FR-A-2 447 584**
**FR-A-2 497 994**
**US-A-4 393 110**

**PATENTS ABSTRACTS OF JAPAN, vol. 3, no.
129 (E-147), 26th October 1979, page 131 E 147
& JP-A-54107308**

(73) Proprietor: **PLASMON DATA SYSTEMS N.V.
De Ruyterkade 58a
Curacao (AN)**

(72) Inventor: **Humberstone, Victor Carey
22 Greenfield Close
Stapleford Cambridgeshire (GB)**
Inventor: **Pettigrew, Robert Martin
Pound Cottage High Street
Foxton Cambridgeshire (GB)**
Inventor: **Helfet, Peter Roy
5 Meadow Drive
London NW4 1SD (GB)**

(74) Representative: **Abrams, Michael John et al
HASELTINE LAKE & CO. Hazlitt House 28
Southampton Buildings Chancery Lane
London WC2A 1AT (GB)**

Courier Press, Leamington Spa, England.

Description

This invention relates to a data storage medium, and to methods of recording data and reading recorded data from such a medium. In particular, the invention is concerned with magneto-optic techniques.

In information storage and retrieval systems, the following characteristics are desirable: (1) to minimise the size of a distinguishable feature in the record (in digital records this is a "bit"); (2) to minimise the energy requirements to write one bit; (3) to maximise the writing speed or number of bits written per second; (4) to maximise the reading speed of recorded information; (5) to maximise the signal level obtained when reading recorded information; (6) to maximise the signal-to-noise ratio during reading, and (7) to maximise the readout contrast.

Several magneto-optic techniques are in theory suitable for use in information storage. These include magnetic writing (i.e. recording) followed by optical reading of the recorded material; thermomagnetic writing/magnetic reading; and thermomagnetic writing/optical reading. The present invention is directed particularly to systems using optical reading or thermomagnetic writing (or both). Where the writing step is a thermomagnetic step, the physical effect produced in the medium by writing (i.e. by the recording process) is, at least in part, magnetic and may for example involve local heating of the medium by the absorption of incident electromagnetic radiation. It is one object of the present invention to provide a magneto-optic memory structure with high sensitivity to writing radiation so that the energy requirement for writing one bit is reduced and the writing speed increased.

Where the readout of magneto-optic memory structures is optical, it may be achieved by observing the change in polarisation state of electromagnetic radiation scattered from the surface. The scattering may be direct transmission or reflection, or scattering in other directions. When the readout radiation is linearly polarised, the change in polarisation state of the scattered light may usually closely be described as a rotation of the polarisation direction. This is closely equivalent to the addition of a polarisation component orthogonal to the incident polarisation in the scatter beam (the added component being the so-called "magneto-optic" component).

This magneto-optic component with orthogonal polarisation "carries" the readout information, but is generally of very small intensity. The scattered component with polarisation parallel to that of the incident radiation, which carries no information, is however, very large. These factors lead to low readout signal-to-noise ratio and low readout contrast which thus limits the usefulness of known magneto-optic memories by reducing the ability to extract stored information from them. In digital storage where "bits" are stored, this results in a "Bit Error Rate" which is larger than is desired for many applications. It is a second object of the present invention to provide means by which the readout signal-to-noise ratio and contrast may be improved in order to improve the readout "Bit Error Rate".

It is a third object of the present invention to realise the improvements in recording sensitivity and readout "Bit Error Rate" using a magnetic-optic structure that may be formed by reliable production techniques.

There are known in the art several multilayer magneto-optic structures which provide improvements in recording sensitivity and readout reliability. These structures consist of combinations of magneto-optic, dielectric and metallic layers deposited in a closely-planar thin-film form. They absorb a significant fraction of the writing illumination, giving higher writing sensitivity. They also aim to increase the intensity of the (information-carrying) magneto-optic component of the scattered radiation, and decrease the intensity of the "ordinary" reflected radiation (i.e. that component polarisation parallel to the incident radiation), giving higher readout reliability. However, further improvement is desired for many applications, especially in the application to computer memories. It is also desired to provide a structure that may be manufactured with higher yields and consequent lower manufacturing costs. The multilayer structures discussed above are difficult to manufacture to the required uniformity of properties within the total storage area of each structure, and between structures.

FR—A—2 497 994 discloses a magneto-optic memory medium comprising a substrate formed with strip-like grooves, a magneto-optic magnetisation (recording) layer having an axis of easy magnetisation perpendicular to its surface, and a reflective layer spaced from the recording layer by a dielectric layer. The grooves constitute guide tracks for a servo-mechanism used in reading the memory device. It is well known that such guide tracks have a width (i.e. pitch or period in this context) which is greater than the wavelength of the radiation used to read data from the memory device. Guide tracks typically are spaced apart by 1.6 microns (1600 nm), and it is generally considered to be unsatisfactory to use spacings of less than 1.2 microns (see "Principles of Optical Disc Systems", by Bouwhuis, Braat et al of Philips Research Laboratories, Eindhoven, published by Adam Hilger Ltd., pages 47—48).

FR—A—2 447 584 describes an optical data storage medium which possesses internal interfacial structure but is not concerned with magneto-optic recording techniques. The storage medium comprises upper and lower structures between which there are formed a series of cavities which exist by virtue of contact between two textured surfaces which are similar in form but have different texture dimensions. Changes in optical properties of the medium occur due to changes in cavity volume.

EP—A—0 025 253 discloses an optical data storage medium the recording mechanism of which is based on the opening of holes in an amorphous layer. Hence it is not concerned with magneto-optic techniques as such. As disclosed, the amorphous layer includes surface discontinuities, e.g. scratches, which provide irregularities which encourage the hole opening mechanism.

DE—A—2 235 574 relates to magneto-optic recording and discloses the provision of thermal isolation of the recording medium by means of rectangular grooves which reduce the thermal conductivity of the magneto-optic film. There is no disclosure of the dimensions of the groove structure.

None of these documents relates to a magneto-optic recording medium having a regular surface texture whose period (pitch) is no greater than the read wavelength used—i.e. whose dimensions are smaller than those of tracking grooves.

EP—A—0 110 729 (application 83307419.8 of the same priority date as the present application) discloses a method of forming an image, which comprises forming a substrate having (1) a surface structure comprising a regular array of grooves or protuberances having a depth in the range 20 to 100 nanometers and a pitch in the range 50 to 700 nanometers, and (2) at or close to said surface structure, a layer of a radiation-sensitive or radiation-absorptive material, and irradiating selected parts of said surface structure with radiation of a pre-determined polarisation, whereby radiation is absorbed at the irradiated parts of the surface so that corresponding areas of the radiation-sensitive or radiation-absorptive layer are affected in a way which makes such areas distinguishable from the remaining areas of the said layer, the radiation-affected parts of said layer thereby constituting an image. Also disclosed is a radiation-sensitive medium comprising a substrate having a surface structure comprising a regular array of grooves or protuberances having a depth in the range 20 to 100 nanometers and a pitch in the range 50 to 700 nanometers; and at or close to said surface structure, a layer of a radiation responsive material, said material and the surface structure being such that irradiation of selected parts of said surface structure with radiation of a predetermined polarisation causes radiation to be absorbed at the irradiated parts of the surface so that corresponding areas of the radiation-responsive layer are affected in a way which makes such areas distinguishable from the remaining areas of the radiation-responsive layer. The radiation-responsive layer may comprise a magneto-optic material.

EP—A—0107379 (Application 83305781.3 having an earlier priority date but published after the filing date of the present application) discloses a data storage medium and method for reading and writing, which medium includes a layer of heat sensitive material having a textured surface pattern the depth of which is at least 100 nm and the pitch of which is typically between 200 and 330 nm and which is overcoated with a thin film of a material which has a high opacity at the wavelength band in which the storage medium operates.

According to one aspect of the present invention, there is provided an optical data storage medium for use in an optical read/write system using an optical read radiation of wavelength W, which medium comprises (a) a substrate; and (b) a layer or a plurality of zones of magneto-optic material, the magneto-optic material being disposed in relation to the structure of the data storage medium as a whole such that it is accessible to incident optical radiation, and which medium has or includes a region which carries a surface texture including raised areas and depressed areas, characterised in that (A) said raised and depressed areas are disposed in a regular array with a period (pitch) measured transversely to the mean surface level of not greater than W, and (B) the medium comprises a layer or a plurality of zones of an optically reflective material.

Where the magneto-optic material is itself optically reflective, this material may constitute the optically reflective material—in other words, the same layer or zones of material fulfill(s) both functions.

The invention also provides methods for recording (writing) and reading such a data-storage medium. The invention further provides a pre-recorded data storage medium having the structure defined above and recorded by a method in accordance with the invention.

For a better understanding of this invention, a number of particular embodiments will now be described in general and specific terms with reference to the accompanying drawings, in which:

Figure 1 represents an enlarged section through a first embodiment;

Figure 2 shows a preferred readout configuration of the embodiment of Figure 1;

Figures 3(a), 3(b) and 3(c) illutrate the reflectivity anomaly of embodiments such as that of Figure 1;

Figure 4 shows plots of the reflected output for different media;

Figures 5(a), 5(b) and 5(c) illustrate deeply textured media in accordance with a second embodiment of the invention;

Figures 6(a) to 6(e) illustrate deeply textured media in accordance with a third embodiment of the invention;

Figures 7(a) to 7(d) illustrate deeply textured media in accordance with a fourth and fifth embodiment of the invention; and

Figure 8 illustrates a medium in accordance with a sixth embodiment of the invention.

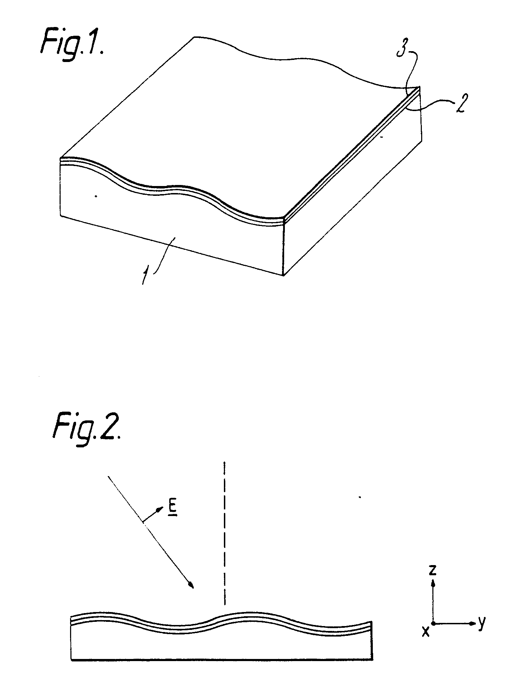

According to one embodiment of the present invention, there is provided a data storage medium comprising a substrate having a slightly textured surface coated with a thin film of a metal which conforms to the texture of the surface and, on top of said thin film of metal, a thin film of magneto-optic material which also conforms to the texture of the substrate surface. If the magneto-optic film is itself highly reflective, the thin metal film may be omitted. Preferably, the magneto-optic film has a thickness in the range of 5—100 nm. One such structure is shown by way of example in Figure 1. The depth of the texture (e.g. the peak to trough dimension where the surface is in the form of a grating) may be very small, for example in the range of 10—50 nm. Alternatively, the depth of the texture may be in the range 50—200 nm. The mean pitch of the texture will usually be smaller than or equal to the wavelength of the writing or reading radiation.

The metal which constitutes the thin film between the substrate and the magneto-optic film is preferably silver, gold, copper or aluminium. This film may, for example, have a thickness in the range 10 to 100 nm.

The magneto-optic film may be overcoated with a thin metallic film of, for example, silver, gold, copper or aluminium. The thickness of such an overcoating film may be in the range 5 to 30 nm.

The texture of the surface may be in the form of a series of alternate grooves and ridges which are substantially parallel. These are preferably uniformly spaced and of uniform depth and shape. Such a surface will be referred to herein as a grating since it is similar to surface relief diffraction gratings which are well known in the spectroscopic art. The texture may consist of two such gratings disposed mutually at an angle. The gratings may be disposed mutually orthogonally. Such a textured surface is referred to as a crossed grating. Many methods of making such gratings are known and include photolithography of an interference field, mechanical ruling and replication from a pre-existing surface.

We have found that materials which are suitable for use as the magneto-optic layer include transition elements, rare earth elements, alloys of at least one rare earth element and at least one transition element, and alloys of at least one transition element and at least one semi-metal. Materials that work satisfactorily include iron, cobalt, nickel, terbium-iron, gadolinium-cobalt, and manganese-bismuth. One particularly favoured material is an amorphous (glassy) alloy of terbium-iron which can possess a magnetisation normal to the film plane when prepared under favourable conditions.

The dielectric constant of at least one of the magneto-optic material and the optically reflective material should preferably have a negative real part and a small imaginary part at the frequency of the radiation in question.

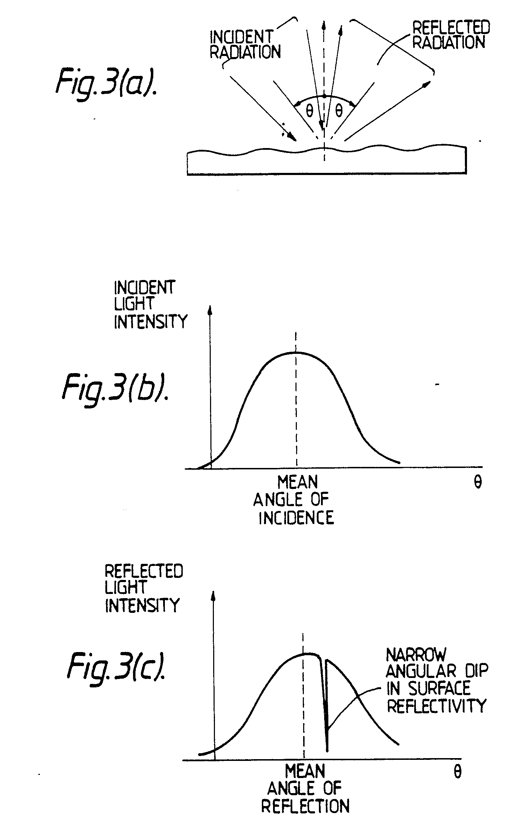

The shallow-texture structure of this first embodiment of the invention provides increase in readout reliability when the illumination has electric vector $E$ linearly polarised parallel to the plane of incidence as shown in Figure 2. We refer to this as polarisation in the plane of incidence. When the surface texture takes the form of a grating the readout beam polarisation should preferably also be closely perpendicular to the grating lines. (This is unnecessary when the texture takes the form of two gratings crossed approximately at right angles).

For readout of small recorded bits, typically having linear dimensions 400 nm to 5000 nm in size, readout illumination of wavelength 400 nm to 1000 nm is highly focussed and therefore impinges on the surface from a wide range of angles. This illuminating radiation has a smooth variation of intensity across this angular range.

The radiation reflected from the surface also emerges in a range of angles, with a primarily smooth variation in intensity across the angular range, but over a small portion of that angular range there may be observed a strong dip in intensity. This is shown in Figures 3(a), (b), (c). A photo-detector viewing at the angular position of this dip (through an appropriately oriented analyser) observes a much increased intensity of the information-carrying magneto-optic component. It also observes a much reduced intensity of radiation component polarised parallel to the incident radiation (the ordinary reflectivity component). As a result both the readout contrast and the readout signal-to-noise ratio are greatly improved. Accordingly, the invention further provides a method of reading data stored on an optical data storage medium using read radiation of wavelength W, the optical data storage medium being one which has or includes a region which carries a surface texture including raised areas and depressed areas which are disposed in a regular array in the form of two gratings which intersect approximately at right angles, said array having a period (pitch) measured transversely to the mean surface level of not greater than W, the medium comprising:

(a) a substrate (1);

(b) a layer or a plurality of zones of magneto-optic material (3); and

(c) a layer or a plurality of zones of an optically reflective material (2) (which may be constituted by said layer or zones of magneto-optic material if the magneto-optic material is inherently optically reflective), the magneto-optic material (3) being disposed in relation to the structure of the data storage medium as a whole such that it is accessible to incident optical radiation, which method comprises (i) directing at said medium a beam of radiation the electric vector $E$ of which is linearly polarised parallel to the plane of incidence; and (ii) monitoring the intensity of the magneto-optic signal within the angular range over which there occurs a sharp reduction (dip) in reflectivity as the surface of the medium is observed or scanned with the read-out illumination. The invention also provides a variation of this method, which consists of a method of reading data stored on an optical data storage medium using read radiation of wavelength W, the optical data storage medium being one which has or includes a region which carries a surface texture including raised areas and depressed areas which are disposed in a regular array in the form of a single grating, said array having a period (pitch) measured transversely to the mean surface level of not greater than W, the medium comprising:

(a) a substrate (1);

(b) a layer or a plurality of zones of magneto-optic material (3); and

(c) a layer or a plurality of zones of an optically reflective material (2) (which may be constituted by said layer or zones of magneto-optic material if the magneto-optic material is inherently optically reflective),

the magneto-optic material (3) being disposed in relation to the structure of the data storage medium as a whole such that it is accessible to incident optical radiation, which method comprises (i) directing at said medium a beam of radiation the electric vector $E$ of which is linearly polarised parallel to the plane of incidence and perpendicular to the lines of the grating; and (ii) monitoring the angular position at which there occurs a sharp reduction (dip) in reflection from the medium as the surface thereof is observed or scanned with the read-out radiation.

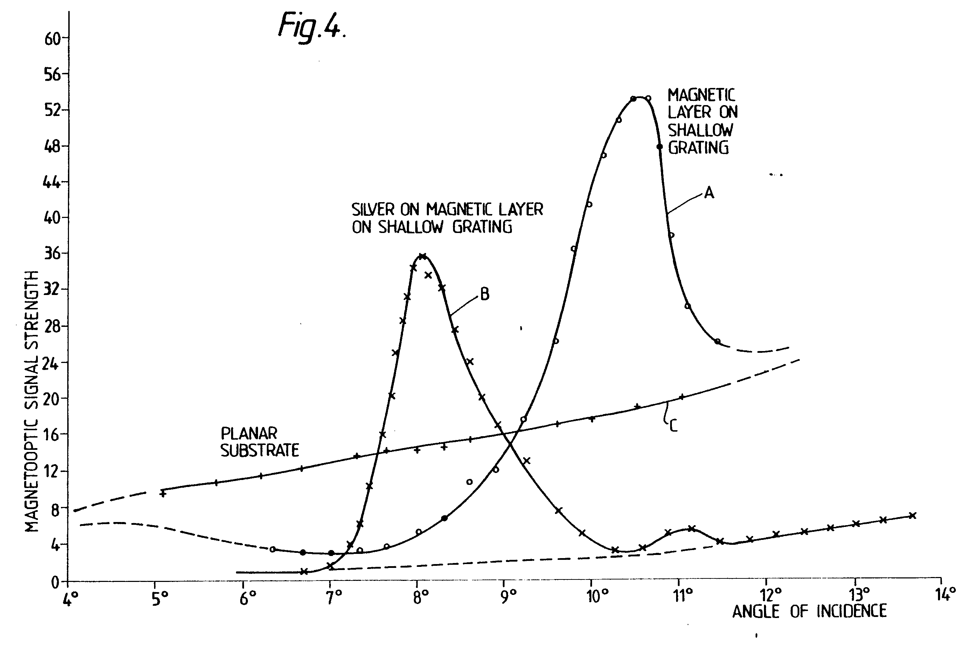

Figure 4 shows experimentally-measured graphs of the intensity of the information-carrying component at and close to this dip in surface reflectivity. In Figure 4, plot A is for a magneto-optic layer on a shallow grating surface such as that of Figure 1; plot B is for a similar structure, but with a layer of silver on top of the magneto-optic layer; and plot C is for a planar substrate.

If the surface reflectivity dip is very sharp, which occurs for highly-reflective metallic or magnetic metallic layers on the surface texture, then the position of the dip noticeably changes upon reversal of the magnetisation direction of the magnetic layer. An alternative readout method is, therefore, the measurement of the angular position of the reflectivity dip. Accordingly the invention also provides a second method of reading data stored on an optical data storage medium using read radiation of wavelength W, the optical data storage medium being one which has or includes a region which carries a surface texture including raised areas and depressed areas which are disposed in a regular array in the form of two gratings which intersect approximately at right angles, said array having a period (pitch) measured transversely to the mean surface level of not greater than W, the medium comprising:

(a) a substrate (1);

(b) a layer or a plurality of zones of magneto-optic material (3); and

(c) a layer or a plurality of zones of an optically reflective material (2) (which may be constituted by said layer or zones of magneto-optic material if the magneto-optic material is inherently optically reflective),

the magneto-optic material (3) being disposed in relation to the structure of the data storage medium as a whole such that it is accessible to incident optical radiation, which method comprises (i) directing at said medium a beam of radiation the electric vector $E$ of which is linearly polarised parallel to the plane of incidence; and (ii) of reading data stored on a data storage medium, which method comprises monitoring the angular position at which there occurs a sharp reduction (dip) in reflection from the medium as the surface thereof is observed or scanned with the read-out radiation. The invention also provides a variation of this second method, which consists of a method of reading data stored on an optical data storage medium using read radiation of wavelength W, the optical data storage medium being one which has or includes a region which carries a surface texture including raised areas and depressed areas which are disposed in a regular array in the form of a single grating, said array having a period (pitch) measured transversely to the mean surface level of not greater than W, the medium comprising:

(a) a substrate (1);

(b) a layer or a plurality of zones of magneto-optic material (3); and

(c) a layer or a plurality of zones of an optically reflective material (2) (which may be constituted by said layer or zones of magneto-optic material if the magneto-optic material is inherently optically reflective),

the magneto-optic material (3) being disposed in relation to the structure of the data storage medium as a whole such that it is accessible to incident optical radiation, which method comprises (i) directing at said medium a beam of radiation the electric vector $E$ of which is linearly polarised parallel to the plane of incidence and perpendicular to the lines of the grating; and (ii) monitoring the intensity of the magneto-optic signal within the angular range over which there occurs a sharp reduction (dip) in reflectivity as the surface of the medium is observed or scanned with the read-out radiation. We have not found this approach as useful in obtaining high readout signal-to-noise ratios as the first method.

The origin of the reflectivity dip is attributed to the excitation of collective electronic motion (surface polaritons or plasmons) in the magnetic film by the incident radiation, the surface texture enabling efficient coupling between the incident radiation and this collective electron motion.

This shallow textured surface provides strong absorption over a narrow range of angles, giving a small improvement to writing sensitivity.

We have obtained best results on readout from the shallow textured surface when the surface is in the form of of a sinusoidal profile of depth 25—40 nm, and a period slightly smaller than the wavelength of the readout illumination. The magnetic film is preferably highly reflective, examples being cobalt, terbium-iron, and gadolinium-cobalt; and of thickness in the range of 5 nm to 50 nm. Under these conditions we have obtained 7.5-fold enhancement in the intensity of the magneto-optic component and a two-fold reduction in the intensity of the ordinary reflected component.

For a practical erasable data storage and retrieval medium the "polar" configuration, in which the direction of magnetisation lies perpendicular to the mean surface plane, is preferred because this permits the maximum recording density. In this arrangement preferred materials for the magnetic layer are MnBi, GdCo, TbFe, GdTbFe and other rare earth-transition element alloys.

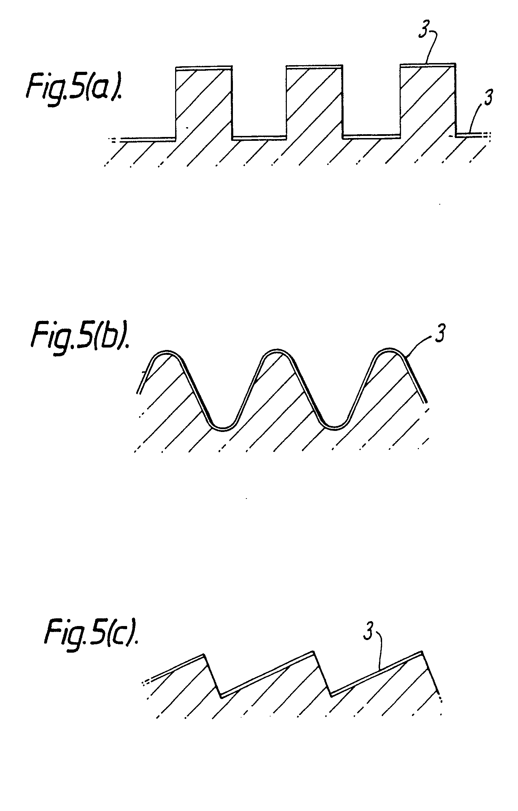

According to a second embodiment of the invention there is provided a data storage medium comprising a substrate having a more deeply textured surface coated with a thin magnetic film which conforms to the texture of the surface. The texture preferably has a mean spatial dimension smaller than the wavelength of the readout radiation and preferably has a depth at least one tenth of the wavelength of the readout radiation, and more preferably at least one sixth thereof. We have found grating profile depths in the range 0.2 W to 0.5 W, where W is the wavelength of the writing or reading illumination, to be particularly advantageous. In the case where the surface is a surface-relief grating the mean spatial dimension is the grating pitch. The surface relief may take the form of a single grating or of two or more gratings disposed mutually at an angle. With two gratings, they may be disposed mutually orthogonally. We have found a single grating to be particularly advantageous. The thin magnetic film may be continuous or discontinuous on the textured surface. Possible examples of this structure are shown in Figures 5(a), (b) and (c). In this and all subsequent Figures, 3 refers to the magnetic layer, 2 to the metallic mirror layer.

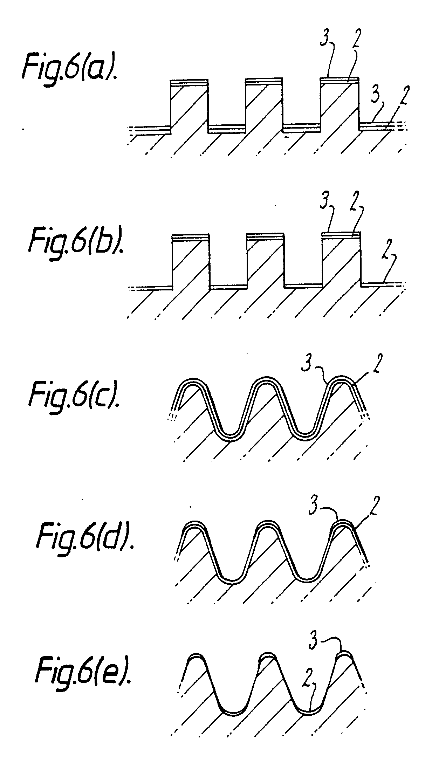

According to a third embodiment of the invention there is provided a data storage medium comprising a substrate having a textured surface of similar depth, period and profile to that described in the second aspect of the invention. This textured surface is coated with a thin metallic film which in turn is coated with a thin magnetic film, both film layers conforming to the texture of the surface. Either or both film layers may be continuous or discontinuous. Examples of this structure are shown in Figures 6(a)—(e) for the top-hat and sinusoidal profiles. Advantageously, the mirror layer is, in the case of the top-hat profile embodiments, located so that the electromagnetic or optical path length between the mirror layer and the lower magneto-optic film is an odd number of quarter-wavelengths of the read or write radiation.

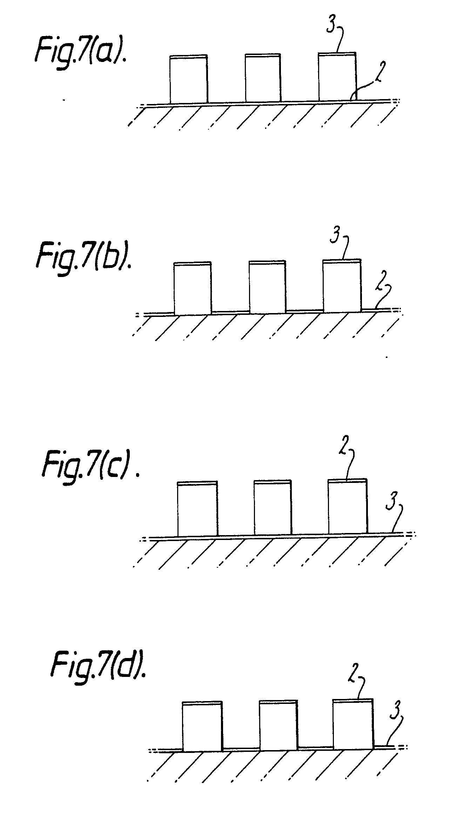

According to a fourth embodiment of the invention a metallic thin film may be deposited on a planar substrate and coated with a dielectric layer that provides a textured surface of similar depth, period and profile to that described in the second aspect of the invention. The dielectric layer is then coated with a magnetic thin film. Either or both film layers may be continuous or discontinuous. Examples of this structure are shown in Figures 7(a) and 7(b), for the top-hat profile.

According to a fifth embodiment of the invention a magnetic thin film may be deposited on a planar substrate and coated with a dielectric layer that provides a textured surface of similar depth, period and profile to that described in the second aspect of the invention. The dielectric layer is then coated with a metallic thin film. Either or both film layers may be continuous or discontinuous. Figures 7(c) and 7(d) show examples of this aspect of the invention.

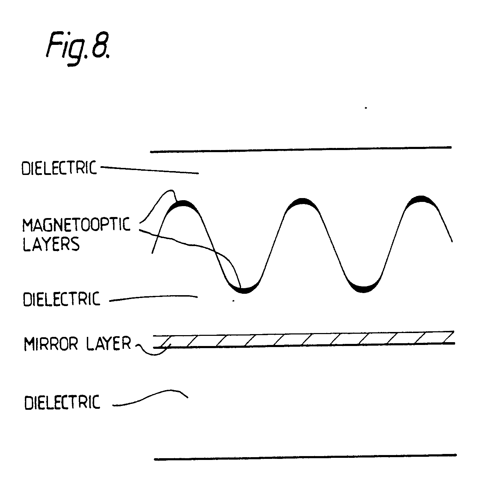

According to a sixth embodiment, a structure of the type defined in any of the first to fifth embodiments is overcoated with a dielectric material to a depth sufficient to give the medium a planar surface. With such a structure, the lower surface of the coating dielectric layer conforms to the textured surface of the substrate plus magneto-optic and/or metallic films. In this embodiment, relatively deep textures are preferred. Figure 8 shows an example of such a structure.

In each of the second, third, fourth, fifth and sixth embodiments of the invention the surface texture may most conveniently take the form of a top-hat (square-wave) or crossed top-hat profile or sinusoidal surface-relief grating or crossed sinusoidal surface-relief grating, although other profiles, for example a triangular or sawtooth profile, are also intended to fall within the scope of this invention. In each case, we have found that particular advantage in either the writing or reading (or both) of data can be achieved when the depth of the grating lies in the range 0.2 times to 0.5 times the wavelength of the writing or reading illumination. For writing, either a crossed grating or a single grating profile confers advantage. For readout, a single grating profile is preferred.

When writing on a single grating profile, we find that, for radiation linearly polarised perpendicular to the grating lines, nearly complete absorption occurs, with very little reflectivity. This high absorption occurs over a wide range of angles of incidence so that even with a very small recorded spot size for which a tightly-focussed cone of radiation is required, almost all the incident radiation energy can be utilized for thermomagnetic recording, giving very high writing sensitivity.

When writing on a crossed grating profile, nearly complete absorption occurs for any polarisation of the incident radiation, again over a wide range of angles of incidence, and very high writing sensitivity is achieved.

For readout from a single grating profile, readout radiation polarised perpendicular to the grating lines gives a very low intensity of the "ordinary" reflection component. Furthermore the high absorption of energy that this represents may produce a much increased magneto-optic component intensity. These combine to give a much increased polarisation rotation angle of the reflected readout illumination. Over a wide range of angles of incidence, we commonly find a fourfold or a fivefold increase in rotation angle over that obtained from a planar magneto-optic film on a planar (non-textured) substrate surface. In general, both the contrast and signal-to-noise ratio on readout from the structure are greatly enhanced.

Excellent performance has been achieved with the structures illustrated in Figures 6(b), (c), (d) and (e) and Figures 7(a)—(d) as the surface texture, using writing and readout radiation polarised in the plane of incidence and perpendicular to the grating lines. For a writing and readout radiation wavelength of 633 nm the preferred pitch and depth of the sinusoidal structure is 150—400 nm, and that for the top-hat structure is 180—300 nm. The thin metallic mirror layer should have thickness adequate to be opaque but should not significantly "in-fill" the structure. Using aluminium as the mirror layer, a thickness of 15—50 nm is appropriate. Upon the crests of the structure is deposited the magnetic layer (which is, therefore, discontinuous across the surface profile), which typically is of thickness in the range of 10—50 nm, and which may be any of the rare-earth-transition element alloys discussed above for the shallow-textured surface in the first embodiment.

The other structures described also provide large improvements in readout performance, but to date we have not observed enhancements as large as those provided by the structures of Figures 6(b), (d), (e) and 7(a)—(d).

The sinusoidal and top-hat structures are preferred for two further production reasons. Firstly the magnetic layers on both types of profile are substantially planar so that the magnetisation direction of the recorded bits is well-defined with respect to the readout illumination, giving maximum magneto-optic signal.

Secondly, these profiles may be fabricated using either photolithography of an interference field or mechanical ruling or replication from a pre-existing surface. In particular for the structures shown in Figures 5 and 6 a "master" grating profile medium can be produced by, for example, the technique of photolithography of an interference field, and electroplating, and many replicas of the profile can be produced by such techniques as embossing, casting, injection moulding, and compression moulding. This gives ease of reliable and repeatable production with high yields.

The magneto-optic layers may alternatively be formed by sputtering or evaporating (at low pressure) a controlled amount of the magneto-optic material onto the textured surface at a controlled angle of deposition.

Materials that we have found suitable for the dielectric (e.g. substrate) layers include polycarbonates, photoresists, polymethylmethacrylate and high-temperature nylons, and polyesters. These materials can simply replicate an existing grating surface profile, by such well known means as embossing and casting. It is possible by these means to replicate a "master" grating surface many times. The dielectric grating profile does not, therefore, have to be constructed for each memory structure. This ease of preparation of the grating profile is to be compared with the fabrication of the multilayer structures, where the fine tolerances required are difficult to achieve and must be reproduced during the manufacture of every structure. In the structures according to this invention, the fine tolerances must be satisfied for the master grating. However, once this is achieved subsequent reproduction of that grating within those tolerances is easily accomplished. The master grating may, for example, take the form of a nickel-electroplating of a grating formed by photolithography, mechanical cutting or other means. The materials listed above by way of example also can withstand without damage the elevated temperatures required for recording information onto and erasing information from the presently preferred magneto-optic materials. Other dielectric materials capable of this include glasses but it is generally less easy to replicate the grating profile of a master grating onto such materials.

Materials that we have found suitable for the high-reflectivity metal layers of the structure include silver, gold, copper and aluminium. Other metals may be similarly effective.

**Claims**

1. An optical data storage medium for use in an optical read/write system using an optical read radiation of wavelength W, which medium comprises (a) a substrate (1); and (b) a layer or a plurality of zones of magneto-optic material (3), the magneto-optic material (3) being disposed in relation to the structure of the data storage medium as a whole such that it is accessible to incident optical radiation, and which medium has or includes a region which carries a surface texture including raised areas and depressed areas, characterised in that (A) said raised and depressed areas are disposed in a regular array with a period (pitch) measured transversely to the mean surface level of not greater than W, and (B) the medium comprises a layer or a plurality of zones of an optically reflective material (2).

2. A medium as claimed in claim 1, characterised in that the magneto-optic material used to form said layer and zones (3) is itself optically reflective and constitutes the layer or zones (2) of optically reflective material.

3. A medium as claimed in claim 1 or 2, characterised in that the magneto-optic film (3) has a thickness in the range of 5—100 nanometers.

4. A medium as claimed in claim 1, characterised in that the magneto-optic film (3) is overcoated with a thin metallic film.

5. A medium as claimed in claim 4, characterised in that said thin metallic film is formed of silver, gold, copper or aluminium.

6. A medium as claimed in claims 4 or 5, characterised in that said thin metallic film is 5 to 30 nanometers in thickness.

7. A medium as claimed in any preceding claim, characterised in that the texture of the surface is in the form of a series of alternate grooves and ridges which are substantially parallel.

8. A medium as claimed in claim 7, characterised in that said grooves and ridges are uniformaly spaced and of uniform depth and shape.

9. A medium as claimed in claim 7 or 8, characterised in that the texture of the surface comprises two series of grooves and ridges disposed mutually at an angle.

10. A medium as claimed in claim 9, characterised in that said two series of grooves and ridges are mutually orthogonal.

11. A medium as claimed in any preceding claim, characterised in that the magneto-optic layer (3) is formed of a transition element, a rare earth element, an alloy of at least one rare earth element and at least one transition element, or an alloy of at least one transition element and at least one semi-metal.

12. A medium as claimed in claim 11, characterised in that the magneto-optic layer (3) consists of iron, cobalt, nickel, terbium-iron, gadolinium-cobalt or manganese-bismuth.

13. A medium as claimed in any preceding claim, characterised in that the textured surface is of sinusoidal profile.

14. A medium as claimed in any preceding claim, characterised in that the depth of the surface texture (peak-to-trough) is in the range 10—50 nanometers.

15. A medium as claimed in any one of claims 1 to 13, characterised in that the depth of the surface texture (peak-to-trough) is in the range 50—200 nm.

16. A medium as claimed in any one of claims 1 to 13, characterised in that the textured surface has a mean spatial dimension smaller than W and has a depth at least one tenth of W.

17. A medium as claimed in claim 13, 14 or 15 or 16, characterised in that the textured surface is in the form of a grating.

18. A medium as claimed in claim 17, characterised in that said grating is of sinusoidal profile.

19. A medium as claimed in claim 17, characterised in that the grating is of square-wave profile.

20. A medium as claimed in claim 17, characterised in that said grating is of saw-tooth profile.

21. A medium as claimed in claim 18 or 19, characterised in that the magneto-optic layer (3) is formed over the raised surface portions (lands) of the grating and over the depressed surface portions (pits) of the grating.

22. A medium as claimed in claim 18 or 19, characterised in that the magneto-optic layer (3) is formed only over the raised surface portions (lands) of the grating only.

23. A medium as claimed in claim 18 or 19, characterised in that the magneto-optic layer (3) is formed only over the depressed surface portions (pits) of the grating.

24. A medium as claimed in preceding claim, characterised in that the magneto-optic layer (3) is formed over or under a metallic mirror layer (2).

25. A medium as claimed in claims 23 and 24, characterised in that the magneto-optic layer is formed over a metallic mirror layer (2), and wherein the metallic mirror layer is also present over the depressed surface portions (pits) of the grating.

26. A medium as claimed in claim 16, 17, 18 or 19, characterised in that a thin metallic film is formed on a planar substrate and is coated with a dielectric layer having said textured surface (Fig. 8), the dielectric layer carrying said magneto-optic layer as a continuous or discontinuous thin film.

27. A medium as claimed in claim 16, 17, 18 or 19, characterised in that wherein the magneto-optic layer is formed on a planar substrate and is coated with a dielectric layer having said textured surface, the surface of said dielectric layer being coated with a thin metallic film which is either continuous or discontinuous.

28. A medium as claimed in any one of claims 16 to 27, characterised in that the textured surface is sinusoidal in profile with a pitch and depth in the range 150—400 nanometers for a read-out radiation, W, of 633 nanometers.

29. A medium as claimed in any one of claims 16 to 27, characterised in that the textured surface is sinusoidal in profile with a pitch and depth in the range 200—550 nanometers for a read-out radiation, W, of 820 nanometers.

30. A medium as claimed in any one of claims 16 to 27, characterised in that the textured surface is of square-wave profile with a pitch and depth in the range 180—300 nanometers for a read-out radiation wavelength, W, of 633 nanometers.

31. A medium as claimed in any one of claims 16 to 27, characterised in that the textured surface is of square-wave profile with a pitch and depth in the range 240—400 nanometers for a read-out radiation wavelength, W, of 820 nanometers.

32. A medium as claimed in claim 24, 25 or 26, characterised in that said metallic mirror layer has a thickness in the range 15—50 nanometers.

33. A medium as claimed in any preceding claim, characterised in that the medium further includes an overcoating dielectric layer the lower surface of which conforms to said textured surface, and the upper surface of which is planar.

34. A method of reading data stored on an optical data storage medium using read radiation of wavelength W, the optical data storage medium being one which has or includes a region which carries a surface texture including raised areas and depressed areas which are disposed in a regular array in the form of two gratings which intersect approximately at right angles, said array having a period (pitch) measured transversely to the mean surface level of not greater than W, the medium comprising:

(a) a substrate (1);

(b) a layer or a plurality of zones of magneto-optic material (3); and

(c) a layer or a plurality of zones of an optically reflective material (2) which may be constituted by said layer or zones of magneto-optic material if the magneto-optic material is inherently optically reflective,

the magneto-optic material (3) being disposed in relation to the structure of the data storage medium as a whole such that it is accessible to incident optical radiation, which method comprises (i) directing at said medium a beam of radiation the electric vector $E$ of which is linearly polarised parallel to the plane of incidence; and (ii) monitoring the angular position at which there occurs a sharp reduction (dip) in reflection from the medium as the surface thereof is observed or scanned with the read-out radiation.

35. A method of reading data stored on an optical data storage medium using read radiation of wavelength W, the optical data storage medium being one which has or includes a region which carries a surface texture including raised areas and depressed areas which are disposed in a regular array in the form of two gratings which intersect approximately at right angles, said array having a period (pitch) measured transversely to the mean surface level of not greater than W, the medium comprising:

(a) a substrate (1);

(b) a layer or a plurality of zones of magneto-optic material (3); and

(c) a layer or a plurality of zones of an optically reflective material (2) which may be constituted by said layer or zones of magneto-optic material if the magneto-optic material is inherently optically reflective,

the magneto-optic material (3) being disposed in relation to the structure of the data storage medium as a whole such that it is accessible to incident optical radiation, which method comprises (i) directing at said medium a beam of radiation the electric vector $E$ of which is linearly polarised parallel to the plane of incidence; and (ii) monitoring the intensity of the magneto-optic signal within the angular range over which there occurs a sharp reduction (dip) in reflectivity as the surface of the medium is observed or scanned with the read-out radiation.

36. A method of reading data stored on an optical data storage medium using read radiation of wavelength W, the optical data storage medium being one which has or includes a region which carries a surface texture including raised areas and depressed areas which are disposed in a regular array in the form of a single grating, said array having a period (pitch) measured transversely to the mean surface level of not greater than W, the medium comprising:

(a) a substrate (1);

(b) a layer or a plurality of zones of magneto-optic material (3); and

(c) a layer or a plurality of zones of an optically reflective material (2) which may be constituted by said layer or zones of magneto-optic material if the magneto-optic material is inherently optically reflective,

the magneto-optic material (3) being disposed in relation to the structure of the data storage medium as a whole such that it is accessible to incident optical radiation, which method comprises (i) directing at said medium a beam of radiation the electric vector $E$ of which is linearly polarised parallel to the plane of incidence and perpendicular to the lines of the grating; and (ii) monitoring the angular position at which there occurs a sharp reduction (dip) in reflection from the medium as the surface thereof is observed or scanned with the read-out radiation.

37. A method of reading data stored on an optical data storage medium using read radiation of wavelength W, the optical data storage medium being one which has or includes a region which carries a surface texture including raised areas and depressed areas which are disposed in a regular array in the form of a single grating, said array having a period (pitch) measured transversely to the mean surface level of not greater than W, the medium comprising:

(a) a substrate (1);

(b) a layer or a plurality of zones of magneto-optic material (3); and

(c) a layer or a plurality of zones of an optically reflective material (2) which may be constituted by said layer or zones of magneto-optic material if the magneto-optic material is inherently optically reflective,

the magneto-optic material (3) being disposed in relation to the structure of the data storage medium as a whole such that it is accessible to incident optical radiation, which method comprises (i) directing at said medium a beam of radiation the electric vector $E$ of which is linearly polarised parallel to the plane of incidence and perpendicular to the lines of the grating; and (ii) monitoring the intensity of the magneto-optic signal within the angular range over which there occurs a sharp reduction (dip) in reflectivity as the surface of the medium is observed or scanned with the read-out radiation.

**Patentansprüche**

1. Optisches Datenspeicherungsmedium zur Verwendung in einem optischen Schreib/Lese-System, das eine optische Lesestrahlung der Wellenlänge W verwednet, welches Medium umfasst: (a) ein Substrat (1); und (b) eine Schicht oder eine Mehrzahl von Zonen aus magnetooptischem Material (3), wobei das magnetooptische Material (3) in bezug auf die Gesamtstruktur des Datenspeicherungsmediums so angeordnet ist, dass es für eintreffende optische Strahlung erreichbar ist, und wobei dieses Medium eine Region aufweist oder umfasst, die eine erhobene Bereiche und vertiefte Bereiche umfassende Oberflächentextur trägt, dadurch gekennzeichnet, dass (A) diese erhobenen und vertieften Bereiche in einer regelmässigen Matrix mit einer rechtwinklig zur mittleren Oberflächenlage gemessenen Periode (Schrittlänge) von nicht mehr als W angeordnet sind und (B) das Medium eine Schicht oder eine Mehrzahl von Zonen aus optisch reflektierendem Material (2) umfasst.

2. Medium nach Anspruch 1, dadurch gekennzeichnet, dass das zur Bildung dieser Schicht oder Zonen (3) verwendete magnetooptische Material selbst optisch reflektierend ist und die Schicht oder Zonen (2) aus optisch reflektierendem Material bildet.

3. Medium nach Anspruch 1 oder 2, dadurch gekennzeichnet, dass die magnetooptische Schicht (3) eine Dicke im Bereich von 5 bis 100 Nanometer aufweist.

4. Medium nach Anspruch 1, dadurch gekennzeichnet, dass die magnetooptische Schicht (3) mit einer metallischen Dünnschicht überzogen ist.

5. Medium nach Anspruch 4, dadurch gekennzeichnet, dass diese metallische Dünnschicht aus Silber, Gold, Kupfer oder Aluminium besteht.

6. Medium nach Anspruch 4 oder 5, dadurch gekennzeichnet, dass diese metallische Dünnschicht eine Dicke von 5 bis 30 Nanometer aufweist.

7. Medium nach einem der vorangehenden Ansprüche, dadurch gekennzeichnet, dass die Oberflächentextur in Form einer Reihe von miteinander abwechselnden und einander im wesentlichen parallelen Vertiefungen und Erhebungen vorliegt.

8. Medium nach Anspruch 7, dadurch gekennzeichnet, dass diese Vertiefungen und Erhebungen voneinander gleichmässig beabstandet und von gleichmässiger Tiefe und Form sind.

9. Medium nach Anspruch 7 oder 8, dadurch gekennzeichnet, dass die Oberflächentextur zwei Reihen von Vertiefungen und Erhebungen umfasst, die im Winkel zueinander angeordnet sind.

10. Medium nach Anspruch 9, dadurch gekennzeichnet, dass diese Reihen von Vertiefungen und Erhebungen rechtwinklig zueinander angeordnet sind.

11. Medium nach einem der vorangehenden Ansprüche, dadurch gekennzeichnet, dass die magnetooptische Schicht (3) aus einem Übergangselement, einem Element der seltenen Erden, einer Legierung von mindestens einem Element der seltenen Erden mit mindestens einem Übergangselement oder einer Legierung von mindestens einem Übergangselement mit mindestens einem Halbmetall gebildet ist.

12. Medium nach Anspruch 11, dadurch gekennzeichnet, dass die magnetooptische Schicht (3) aus Eisen, Kobalt, Nickel, Terbium-Eisen, Gadolinium-Kobalt oder Mangan-Wismuth besteht.

13. Medium nach einem der vorangehenden Ansprüche, dadurch gekennzeichnet, dass die Oberflächentextur ein sinusförmiges Profil aufweist.

14. Medium nach einem der vorangehenden Ansprüche, dadurch gekennzeichnet, dass die Tiefe der Oberflächentextur (Wellenberg zu Wellental) im Bereich von 5 bis 50 Nanometer liegt.

15. Medium nach einem der Ansprüche 1 bis 13, dadurch gekennzeichnet, dass die Tiefe der Oberflächentextur (Wellenberg zu Wellental) im Bereich von 50 bis 200 Nanometer liegt.

16. Medium nach einem der Ansprüche 1 bis 13, dadurch gekennzeichnet, dass die Oberflächentextur eine mittlere räumliche Dimension aufweist, die kleiner als W ist, und eine Tiefe aufweist, die mindestens ein Zehntel von W beträgt.

17. Medium nach Anspruch 13, 14, 15 oder 16, dadurch gekennzeichnet, dass die Oberflächentextur in Form eines Gitters vorliegt.

18. Medium nach Anspruch 17, dadurch gekennzeichnet, dass das Gitter ein sinusförmiges Profil aufweist.

19. Medium nach Anspruch 17, dadurch gekennzeichnet, dass das Gitter ein rechteckförmiges Profil aufweist.

20. Medium nach Anspruch 17, dadurch gekennzeichnet, dass das Gitter ein sägezahnförmiges Profil aufweist.

21. Medium nach Anspruch 18 oder 19, dadurch gekennzeichnet, dass die magnetooptische Schicht (3) über den erhobenen Oberflächenteilen (Inseln) des Gitters und über den vertieften Oberflächenteilen (Nuten) des Gitters gebildet ist.

22. Medium nach Anspruch 18 oder 19, dadurch gekennzeichnet, dass die magnetooptische Schicht (3) nur über den erhobenen Oberflächenteilen (Inseln) des Gitters gebildet ist.

23. Medium nach Anspruch 18 oder 19, dadurch gekennzeichnet, dass die magnetooptische Schicht (3) nur über den vertieften Oberflächenteilen (Rillen) des Gitters gebildet ist.

24. Medium nach einem der vorangehenden Ansprüche, dadurch gekennzeichnet, dass die magnetooptische Schicht (3) über oder unter einer metallischen Spiegelschicht (2) gebildet ist.

25. Medium nach den Ansprüchen 23 und 24, dadurch gekennzeichnet, dass die magnetooptische Schicht über einer metallischen Spiegelschicht (2) gebildet und die metallische Spiegelschicht auch über den vertieften Oberflächenteilen (Rillen) des Gitters vorhanden ist.

26. Medium nach Anspruch 16, 17, 18 oder 19, dadurch gekennzeichnet, dass die metallische Dünnschicht auf einem ebenen Substrat gebildet und mit einer eine texturierte Oberfläche (Fig. 8) aufweisenden dielektrischen Schicht überzogen ist, wobei die dielektrische Schicht die magnetooptische Schicht als ununterbrochene oder unterbrochene Dünnschicht trägt.

27. Medium nach Anspruch 16, 17, 18 oder 19, dadurch gekennzeichnet, dass die magnetooptische Schicht auf einem ebenen Substrat gebildet und mit einer eine texturierte Oberfläche aufweisenden dielektrischen Schicht überzogen ist, wobei die Oberfläche der dielektrischen Schicht von einer metallischen Dünnschicht überzogen ist, die entweder ununterbrochen oder unterbrochen ist.

28. Medium nach einem der Ansprüche 16 bis 27, dadurch gekennzeichnet, dass die texturierte Oberfläche ein sinusförmiges Profil mit einem Schritt und einer Tiefe im Bereich von 150 bis 400 Nanometer für eine Lesestrahlung mit einer Wellenlänge W von 633 Nanometer aufweist.

29. Medium nach einem der Ansprüche 16 bis 27, dadurch gekennzeichnet, dass die texturierte Oberfläche ein sinusförmiges Profil mit einem Schritt und einer Teife im Bereich von 200 bis 550 Nanometer für eine Lesestrahlung mit einer Wellenlänge W von 820 Nanometer aufweist.

30. Medium nach einem der Ansprüche 16 bis 27, dadurch gekennzeichnet, dass die texturierte Oberfläche ein rechteckförmiges Profil mit einem Schritt und einer Tiefe im Bereich von 180 bis 300 Nanometer für eine Lesestrahlung mit einer Wellenlänge W von 633 Nanometer aufweist.

31. Medium nach einem der Ansprüche 16 bis 27, dadurch gekennzeichnet, dass die texturierte Oberfläche ein rechteckförmiges Profil mit einem Schritt und einer Tiefe im Bereich von 240 bis 400 Nanometer für eine Lesestrahlung mit einer Wellenlänge W von 820 Nanometer aufweist.

32. Medium nach Anspruch 24, 25 oder 26, dadurch gekennzeichnet, dass die metallische Spiegelschicht eine Dicke im Bereich von 15 bis 50 Nanometer aufweist.

33. Medium nach einem der vorangehenden Ansprüche, dadurch gekennzeichnet, dass das Medium ausserdem eine überdeckende dielektrische Schicht umfasst, deren untere Fläche sich an die texturierte Oberfläche anschmiegt und der obere Fläche eben ist.

34. Verfahren zum Lesen von Daten, die auf einem optischen Datenspeicherungsmedium gespeichert sind, unter Verwendung einer Lesestrahlung der Wellenlänge W, wobei das optische Datenspeicherungsmedium ein solches ist, das eine Region aufweist oder umfasst, die eine erhobene Bereiche und vertiefte Bereiche umfassende Oberflächentextur trägt, welche Bereiche in einer regelmässigen Matrix in Form von zwei Gittern angeordnet sind, die annähernd rechtwinklig gekreuzt sind, wobei diese Matrix eine rechtwinklig zur mittleren Oberflächenlage gemessene Periode (Schrittlänge) von nicht mehr als W aufweist, und das Medium umfasst:

(a) ein Substrat (1);

(b) eine Schicht oder eine Mehrzahl von Zonen aus magnetooptischem Material (3); und

(c) eine Schicht oder eine Mehrzahl von Zonen aus optisch reflektierendem Material (2), das aus dieser Schicht oder dieser Mehrzahl von Zonen aus magnetooptischem Material bestehen kann, wenn das magnetooptische Material an sich optisch reflektierend ist,

wobei das magnetooptische Material (3) in bezug auf die Gesamtstruktur des Datenspeicherungsmediums so angeordnet ist, dass es für eintreffende optische Strahlung erreichbar ist, welches Verfahren folgendes umfasst: (i) man richtet auf dieses Medium einen Strahl von einer Strahlung, deren elektrischer Vektor $E$ parallel zur Einfallsebene linear polarisiert ist; und (ii) man erfasst die Winkellage, bei welcher eine scharfe Abnahme (Taucher) der Spiegelung durch das Medium erfolgt, wenn man dessen Oberfläche mit der Lesestrahlung betrachtet oder abtastet.

35. Verfahren zum Lesen von Daten, die auf einem optischen Datenspeicherungsmedium gespeichert sind, unter Verwendung einer Lesestrahlung der Wellenlänge W, wobei das optische Datenspeicherungsmedium ein solches ist, das eine Region aufweist oder umfasst, die eine erhobene Bereiche und vertiefte Bereiche umfassende Oberflächentextur trägt, welche Bereiche in einer regelmässigen Matrix in Form von zwei Gittern angeordnet sind, die annähernd rechtwinklig gekreuzt sind, wobei diese Matrix eine rechtwinklig zur mittleren Oberflächenlage gemessene Periode (Schrittlänge) von nicht mehr als W aufweist, und das Medium umfasst:

(a) ein Substrat (1);

(b) eine Schicht oder eine Mehrzahl von Zonen aus magnetooptischem Material (3); und

(c) eine Schicht oder eine Mehrzahl von Zonen aus optische reflektierendem Material (2), das aus dieser Schicht oder dieser Mehrzahl von Zonen aus magnetooptischem Material bestehen kann, wenn das magnetooptische Material an sich optisch reflektierend ist,

wobei das magnetooptische Material (3) in bezug auf die Gesamtstruktur des Datenspeicherungsmediums so angeordnet ist, dass es für eintreffende optische Strahlung erreichbar ist, welches Verfahren folgendes umfasst: (i) man richtet auf dieses Medium einen Strahl von einer Strahlung, deren elektrischer Vektor $E$ parallel zur Einfallsebene linear polarisiert ist; und (ii) man erfasst die Intensität des magnetooptischen Signals innerhalb des Winkelbereiches, in welchem eine scharfe Abnahme (Taucher) der Reflektivität erfolgt, wenn man die Oberfläche des Mediums mit der Lesestrahlung betrachtet oder abtastet.

36. Verfahren zum Lesen von Daten, die auf einem optischen Datenspeicherungsmedium gespeichert sind, unter Verwendung einer Lesestrahlung der Wellenlänge W, wobei das optische Datenspeicherungsmedium ein solches ist, das eine Region aufweist oder umfasst, die eine erhobene Bereiche und vertiefte Bereiche umfassende Oberflächentextur trägt, welche Bereiche in einer regelmässigen Matrix in Form von einem einzigen Gitter angeordnet sind, wobei diese Matrix eine rechtwinklig zur mittleren Oberflächenlage gemessene Periode (Schrittlänge) von nicht mehr als W aufweist, und das Medium umfasst:

(a) ein Substrat (1);

(b) eine Schicht oder eine Mehrzahl von Zonen aus magnetooptischem Material (3); und

(c) eine Schicht oder eine Mehrzahl von Zonen aus optisch reflektierendem Material (2), das aus dieser Schicht oder dieser Mehrzahl von Zonen aus magnetooptischem Material bestehen kann, wenn das magnetooptische Material an sich optisch reflektierend ist,

wobei das magnetooptische Material (3) in bezug auf die Gesamtstruktur des Datenspeicherungsmediums so angeordnet ist, dass es für eintreffende optische Strahlung erreichbar ist, welches Verfahren folgendes umfasst: (i) man richtet auf dieses Medium einen Strahl von einer Strahlung, deren elektrischer Vektor $E$ parallel zur Einfallsebene und rechtwinklig zu den Linien des Gitters linear polarisiert ist; und (ii) man erfasst die Winkellage, bei welcher eine scharfe Abnahme (Taucher) der Spiegelung durch das Medium erfolgt, wenn man dessen Oberfläche mit der Lesestrahlung betrachtet oder abtastet.

37. Verfahren zum Lesen von Daten, die auf einem optischen Datenspeicherungsmedium gespeichert sind, unter Verwendung einer Lesestrahlung der Wellenlänge W, wobei das optische Datenspeicherungsmedium ein solches ist, das eine Region aufweist oder umfasst, die eine erhobene Bereiche und vertiefte Bereiche umfassende Oberflächentextur trägt, welche Bereiche in einer regelmässigen Matrix in Form von einem einzigen Gitter angeordnet sind, wobei diese Matrix eine rechtwinklig zur mittleren Oberflächenlage gemessene Periode (Schrittlänge) von nicht mehr als W aufweist, und das Medium umfasst:

(a) ein Substrat (1);

(b) eine Schicht oder eine Mehrzahl von Zonen aus magnetooptischem Material (3); und

(c) eine Schicht oder eine Mehrzahl von Zonen aus optisch reflektierendem Material (2, das aus dieser Schicht oder dieser Mehrzahl von Zonen aus magnetooptischem Material bestehen kann, wenn das magnetooptische Material an sich optisch reflektierend ist,

wobei das magnetooptische Material (3) in bezug auf die Gesamtstruktur des Datenspeicherungsmediums so angeordnet ist, dass es für eintreffende optische Strahlung erreichbar ist, welches Verfahren folgendes umfasst: (i) man richtet auf dieses Medium einen Strahl von einer Strahlung, deren elektrischer Vektor *E* parallel zur Einfallsebene und rechtwinklig zu den Linien des Gitters linear polarisiert ist; und (ii) man erfasst die Intensität des magnetooptischen Signals innerhalb des Winkelbereiches, in welchem eine scharfe Abnahme (Taucher) der Reflektivität erfolgt, wenn man die Oberfläche des Mediums mit der Lesestrahlung betrachtet oder abtastet.

**Revendications**

1. Support de mémorisation optique de données destiné à un système de lecture/écriture optique utilisant un rayonnement de lecture optique de longueur d'onde W, ce support comportant (a) un substrat (1); et (b) une couche ou plusieurs zones de matière magnéto-optique (3), la matière magnéto-optique (3) étant disposée en relation avec la structure du support de mémorisation de données comme un ensemble de manière qu'elle soit accessible à un rayonnement optique incident, et ce support comportant ou contenant une région qui porte une texture de surface comportant des régions en relief et des régions en creux, caractérisé en ce que (A) lesdites régions en relief et en creux sont disposées en un réseau régulier avec une période (pas) mesurée transversalement par rapport au niveau de surface moyen n'étant pas supérieure à W et (B) le support comportant une couche ou plusieurs zones d'une matière réfléchissante optiquement (2).

2. Support selon la revendication 1, caractérisé en ce que la matière magnéto-optique utilisée pour former ladite couche et les zones (3), est elle-même réfléchissante optiquement et constitue la couche ou les zones (2) de matière réfléchissante optiquement.

3. Support selon la revendication 1 ou 2, caractérisé en ce que la pellicule magnéto-optique (3) a une épaisseur dans la plage de 5 à 100 nanomètres.

4. Support selon la revendication 1, caractérisé en ce que la pellicule magnéto-optique (3) est revêtue d'une mince pellicule métallique.

5. Support selon la revendication 4, caractérisé en ce que ladite mince couche métallique est faite d'argent, d'or, de cuivre ou d'aluminium.

6. Support selon la revendication 4 ou 5, caractérisé en ce que ladite mince pellicule métallique a une épaisseur de 5 à 30 nanomètres.

7. Support selon l'une quelconque des revendications précédentes, caractérisé en ce que la texture de la surface se présente sous la forme d'une série de rainures et de nervures alternées qui sont pratiquement parallèles.

8. Support selon la revendication 7, caractérisé en ce que lesdites rainures et lesdites nervures sont espacées uniformément et de forme et de profondeur uniformes.

9. Support selon la revendication 7 ou 8, caractérisé en ce que la texture de la surface consiste en deux séries de rainures et de nervures disposées mutuellement sous un angle.

10. Support selon la revendication 9, caractérisé en ce que lesdites deux séries de rainures et de nervures sont mutuellement perpendiculaires.

11. Support selon l'une quelconque des revendications précédentes, caractérisé en ce que la couche magnéto-optique (3) est formée d'un élément de transition, un élément de terre rare, un alliage d'au moins un élément de terre rare et d'au moins un élément de transition ou d'un alliage d'au moins un élément de transition et d'au moins un semi-métal.

12. Support selon la revendication 11, caractérisé en ce que la couche magnéto-optique (3) consiste en du fer, du cobalt, du nickel, du terbium-fer, du gadolinium-cobalt ou du manganèse-bismuth.

13. Support selon l'une quelconque des revendications précédentes, caractérisé en ce que la surface texturée a un profil sinusoïdal.

14. Support selon l'une quelconque des revendications précédentes, caractérisé en ce que la profondeur de la texture de surface (crête à fond) se situe dans la plage de 10 à 50 nanomètres.

15. Support selon l'une quelconque des revendications 1 à 13, caractérisé en ce que la profondeur de la texture de surface (crête à fond) se situe dans la plage de 50 à 200 nanomètres.

16. Support selon l'une quelconque des revendications 1 à 13, caractérisé en ce que la surface texturée a une dimension spatiale moyenne inférieure à W et a une profondeur d'au moins un dixième de W.

17. Support selon la revendication 13, 14 ou 15 ou 16, caractérisé en ce que la surface texturée se présente sous la forme d'un réseau.

18. Support selon la revendication 17, caractérisé en ce que ledit réseau a un profil sinusoïdal.

19. Support selon la revendication 17, caractérisé en ce que le réseau a un profil rectangulaire.

20. Support selon la revendication 17, caractérisé en ce que ledit réseau a un profil en dent de scie.

21. Support selon la revendication 18 ou 19, caractérisé en ce que la couche magnéto-optique (3) est formée sur les parties de surface relevées (plats) du réseau et au-dessus des parties de surface en creux (cavités) du réseau.

22. Support selon la revendication 18 ou 19, caractérisé en ce que la couche magnéto-optique (3) est formée seulement sur les parties de surface en relief (plats) du réseau.

23. Support selon la revendication 18 ou 19, caractérisé en ce que la couche magnéto-optique (3) est formée seulement sur les parties des surfaces en creux (cavités) du réseau.

24. Support selon l'une quelconque des revendications précédentes, caractérisé en ce que la couche magnéto-optique (3) est formée au-dessus ou au-dessous d'une couche miroir métallique (2).

25. Support selon les revendications 23 et 24, caractérisé en ce que la couche magnéto-optique est formée sur une couche miroir métallique (2) et dans lequel la couche miroir métallique est également présente sur les parties de surface en creux (cavités) du réseau.

26. Support selon la revendication 16, 17, 18 ou 19, caractérisé en ce qu'une mince pellicule métallique est formée sur un substrat plan et est revêtue avec une couche diélectrique ayant ladite surface texturée (figure 8), la couche diélectrique portant ladie couche magnéto-optique comme une mince pellicule continue ou discontinue.

27. Support selon la revendication 16, 17, 18 ou 19, caractérisé en ce que la couche magnéto-optique est formée sur un substrat plan et est revêtue avec une couche diélectrique ayant ladite surface texturée, la surface de ladite couche diélectrique étant revêtue d'une mince pellicule métallique qui est continue ou discontinue.

28. Support selon l'une quelconque des revendications 16 à 27, caractérisé en ce que la surface texturée a un profil sinusoïdal avec un pas et une profondeur dans la plage de 150 à 400 nanomètres pour un rayonnement de lecture, W, de 633 nanomètres.

29. Support selon l'une quelconque des revendications 16 à 27, caractérisé en ce que la surface texturée a un profil sinusoïdal avec un pas et une profondeur dans la palge de 200 à 550 nanomètres pour un rayonnement de lecture, W, de 820 Nanomètres.

30. Support selon l'une quelconque des revendications 16 à 27, caractérisé en ce que la surface texturée a un profil rectangulaire avec un pas et une profondeur dans la plage de 180 à 300 nanomètres pour une longueur d'onde de rayonnement de lecture, W, de 633 nanomètres.

31. Support selon l'une des revendications 16 à 27, caractérisé en ce que la surface texturée a un profil rectangulaire avec un pas et une profondeur dans la plage de 240 à 400 nanomètres pour une longueur de rayonnement de lecture, W, de 820 nanomètres.

32. Support selon la revendication 24, 25 ou 26, caractérisé en ce que ladite couche miroir métallique a une épaisseur dans la plage de 15 à 50 nanomètres.

33. Support selon l'une quelconque des revendications précédentes, caractérisé en ce qu'il comporte en outre une couche diélectrique de revêtement dont la surface inférieure épouse ladite surface texturée et dont la surface supérieure est plane.

34. Procédé de lecture de données mémorisées sur un support de mémorisation optique de données utilisant un rayonnement de lecture de longueur d'onde W, le support de mémorisation optique de données étant l'un qui comporte ou contient une région qui porte une texture de surface comprenant des régions en relief et des régions en creux qui sont disposées en un réseau régulier sous la forme de deux réseaux qui se coupent à peu près à angle droit, ledit réseau ayant une période (pas) mesurée transversalement par rapport au niveau de surface moyen n'étant pas supérieur à W, le support comportant:

(a) un substrat (1);

(b) une couche ou plusieurs zones de matière magnéto-optique (3); et

(c) une couche ou plusieurs zones d'une matière réfléchissante optiquement (2) qui peut être constituée par ladite couche ou lesdites zones de matière magnéto-optique si cette matière magnéto-optique est de par nature réfléchissante optiquement,

la matière magnéto-optique (3) étant disposée en relation avec la structure du support de mémorisation de données comme un ensemble de manière qu'elle soit accessible à un rayonnement optique incident, le procédé consistant (i) à diriger sur ledit support un faisceau de rayonnement dont le vecteur électrique E est polarisé linéairement, parallèlement au plan d'incidence; et (ii) à contrôler la position angulaire à laquelle se produit une brusque réduction (profondeur) de réflexion par le support quand sa surface, observée ou explorée avec le rayonnement de lecture.

35. Procédé de lecture de données mémorisées sur un support de mémorisation optique de données utilisant un rayonnement de lecture de longueur d'onde W, le support de mémorisation optique de données étant l'un qui comporte ou qui contient une région portant une texture de surface comprenant des régions en relief et des régions en creux qui sont disposées en un réseau régulier sous la forme de deux réseaux qui se coupent à peu près à angle droit, ledit réseau ayant une période (pas) mesurée transverslement par rapport au niveau de surface moyen n'étant pas supérieur à W, le support comportant:

(a) un substrat (1);

(b) une couche ou plusieurs zones de matière magnéto-optique (3); et

(c) une couche ou plusieurs zones d'une matière réfléchissante optiquement (2) qui peut être constituée par ladite couche ou lesdites zones de matière magnéto-optique si cette matière magnéto-optique est de par nature réfléchissante optiquement.

la matière magnéto-optique (3) étant disposée en relation avec la structure du support de mémorisation de données comme un ensemble de manière qu'elle soit accessible à un rayonnement optique incident, ce procédé consistant (i) à diriger vers ledit support un faisceau de rayonnement dont le vecteur électrique E est polarisé linéairement parallèlement au plan d'incidence; et (ii) à contrôler l'intensité du signal magnéto-optique dans une plage angulaire dans laquelle il se produit une réduction brusque (profondeur) de pouvoir réflecteur quand la surface du support est observée ou explorée avec le rayonnement de lecture.

36. Procédé de lecture de données mémorisées sur un support de mémorisation optique de données utilisant un rayonnement de lecture de longueur d'onde W, le support de mémorisation optique de données étant l'un qui comporte ou contient une région qui porte une texture de surface comprenant des régions en relief et des régions en creux qui sont disposées en un ensemble régulier sous la forme d'un simple réseau, ledit ensemble ayant une période (pas) mesurée transversalement par rapport au niveau de surface moyen n'étant pas supérieure à W, le support comportant:

(a) un substrat (1);

(b) une couche ou plusieurs zones de matière magnéto-optique (3); et

(c) une couche ou plusieurs zones d'une matière réfléchissante optiquement (2) qui peut être constituée par ladite couche ou lesdites zones de matière magnéto-optique si cette matière magnéto-optique est de par nature réfléchissante optiquement, la matière magnéto-optique (3) étant disposée en relation avec la structure du support de mémorisation de données comme un ensemble de manière qu'elle soit accessible à un rayonnement optique incident, ce procédé consistant (i) à diriger vers ledit support un faisceau de rayonnement dont le vecteur électrique E est polarisé linéairement, parallèlement au plan d'incidence et perpendiculairement aux raies du réseau; et (ii) à contrôler la position angulaire à laquelle se produit une réduction brusque (profondeur) de réflexion par le support quand sa surface est observée ou explorée avec le rayonnement de lecture.

37. Procédé de lecture de données mémorisées sur un support de mémorisation optique de données utilisant un rayonnement de lecture de longueur d'onde W, le support de mémorisation optique de données étant l'un qui comporte ou contient une région qui porte une texture de surface comprenant des régions en relief et des régions en creux qui sont disposées en un ensemble régulier sous la forme d'un seul réseau, ledit ensemble ayant une période (pas) mesurée transversalement par rapport au niveau de surface moyen n'étant pas supérieure à W, le support comportant:

(a) un substrat (1);

(b) une couche ou plusieurs zones de matière magnéto-optique (3); et

(c) une couche ou plusieurs zones d'une matière réfléchissante optiquement (2) qui peut être constituée par ladite couche ou lesdites zones de matière magnéto-optique si cette matière magnéto-optique est de par nature réfléchissante optiquement,

la matière magnéto-optique (3) étant disposée en relation avec la structure du support de mémorisation de données comme un ensemble de manière qu'elle soit accessible à un rayonnement optique incident, le procédé consistant (i) à diriger sur ledit support un faisceau de rayonnement dont le vecteur électrique E est polarisé linéairement, parallèlement au plan d'incidence et perpendiculairement aux raies du réseau; et (ii) à contrôler l'intensité du signal magnéto-optique dans la plage angulaire dans laquelle se produit une réduction brusque (profondeur) de pouvoir réfléchissant quand la surface du support est observée ou exporée avec le rayonnement de lecture.

*Fig.1.*

*Fig.2.*

Fig.3(a).

INCIDENT
RADIATION

REFLECTED
RADIATION

θ  θ

INCIDENT
LIGHT
INTENSITY

Fig.3(b).

MEAN
ANGLE OF
INCIDENCE

θ

REFLECTED
LIGHT
INTENSITY

Fig.3(c).

NARROW
ANGULAR DIP
IN SURFACE
REFLECTIVITY

MEAN
ANGLE OF
REFLECTION

θ

2

Fig.4.

Fig.5(a).

Fig.5(b).

Fig.5(c).

Fig.6(a).

Fig.6(b).

Fig.6(c).

Fig.6(d).

Fig.6(e).

Fig.7(a).

Fig.7(b).

Fig.7(c).

Fig.7(d).

# Fig.8.

DIELECTRIC

MAGNETOOPTIC
LAYERS

DIELECTRIC

MIRROR LAYER

DIELECTRIC